(19)

Europäisches
Patentamt
European
Patent Office
Office européen
des brevets

(11) **EP 1 764 912 A2**

(12) **EUROPEAN PATENT APPLICATION**

(43) Date of publication:
**21.03.2007 Bulletin 2007/12**

(51) Int Cl.:
*H03B 27/00* (2006.01)     *H03D 3/00* (2006.01)

(21) Application number: **06120371.7**

(22) Date of filing: **08.09.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **15.09.2005 GB 0518847**
**24.10.2005 GB 0521532**

(71) Applicant: **ROKE MANOR RESEARCH LIMITED Romsey,**
**Hampshire SO51 0ZN (GB)**

(72) Inventor: **Trinder, Julian Richard Totton**
**Hampshire SO40 8UQ (GB)**

(74) Representative: **Hazzard, Alan David**
**Siemens AG**
**Postfach 22 16 34**
**80506 Munich (DE)**

(54) **Generation of accurate phase and amplitude matched signals**

(57)     A circuit architecture for generation of amplitude and phase matched signals is described, which is primarily intended for the generation of quadrature signals, for example local oscillator signals, as required in many electronic systems. Using a single reference signal as an input, two output signals are generated at the same frequency. The relative amplitudes of these signals contain phase error information. An error signal is derived by amplitude comparison, and then fed back to a phase control element in a closed loop manner. The method proposed ensures that when the output amplitudes are equal then the output signals will be in phase quadrature. All signal processing is performed at the fundamental frequency, enabling wider bandwidth and higher frequency operation to be achieved, than could otherwise be realised using standard circuits based on frequency dividers.

FIG 3

EP 1 764 912 A2

**Description**

The present invention provides a circuit for generation of amplitude and phase matched signals, which is primarily intended for the generation of quadrature signals, for example local oscillator signals, as required in many electronic systems.

In an electronic communication system, there often exists the need to generate signals with accurate, known relative amplitude and phase. Most usually, the requirement is to generate a pair of signals of identical amplitude, but 90 degree phase difference.

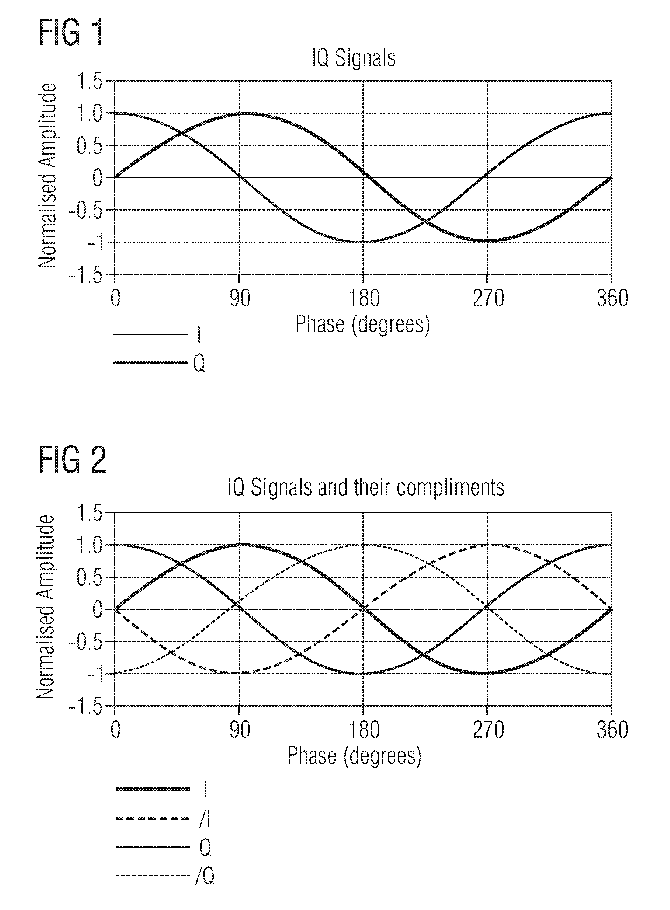

This signal pair is usually referred to by calling one the in-phase signal "I", and the other the quadrature signal "Q" as shown in figure 1. Such signals are commonly used as Local Oscillator (LO) drive signals.

IQ signal pairs may exist as 'single ended signals', or as 'balanced signals'. For the latter case, 'balanced' implies an equal amplitude inverse signal exists as well. In this case the in-phase signals are referred to by I and /I, and the quadrature signals by Q and /Q, as further indicated in figure 2.

In a typical system, one signal is provided (such as 'I') from a signal generator to use as a reference, and then an electronic circuit of some sort is used to generate the remaining signals as required.

For the purpose of this discussion, the problem of IQ signal generation will be broken down into three categories:

    1) Zero Bandwidth IQ Generation
    2) Medium Frequency, Broad Bandwidth IQ Generation
    3) High Frequency, Medium Bandwidth IQ Generation

"Zero Bandwidth" generation, means the system requires I and Q signals to be provided at a spot frequency only. A simple passive phase shift network can generally be used here with adequate results. Hence the solution here is trivial.

Where the IQ signals are required to be provided over some variable frequency bandwidth, the situation becomes more complicated, since the phase of any fixed passive phase shifter as described above, would vary over the band in question. A typical solution, would be to use a reference signal (maybe a square wave, rather than the sine wave shown previously) at four times the desired final frequency. This signal is then passed through a system of divide-by-2 frequency dividers, which generate signals at the appropriate quadrature phases. This sort of system works well where the circuit technology is able to process the signal at four times the required final output frequency or above, without introducing significant errors. This system will work over a very broad bandwidth from near DC to the circuitry limit for processing the highest frequency component. This sort of solution may be termed a "Medium Frequency, Broad Bandwidth" type. It is termed "Medium Frequency", since it can only provide outputs at no more than ¼ of the circuit technology capability. A similar system exists, with double the operating frequency capability, using an input at only twice the desired output frequency, but this demands an accurate 50:50 mark space ratio of the input signal, and still does not utilise the full capability of the technology in its output signal.

Clearly at high frequencies, active circuitry previously described, is no longer appropriate. Instead, passive "hybrid" technology is used. Here, passive structures are employed, whose dimensions are commensurate with signal wavelengths. Various configuratio ns can be employed. A common example is the microstrip branch line coupler, a description of which can be found in most elementary texts on microwave circuit design. These sorts of circuits generally only perform adequately over an octave of bandwidth, and hence are termed here "High Frequency, Medium Bandwidth" types. Clearly these circuits cannot generally be used at low frequencies, since the structures would physically be too large.

Requirements for IQ signal generation are at ever increasing frequencies, and with greater bandwidth demands. The category 2) circuit discussed above addresses bandwidth well, but is limited on upper frequency performance due to the active circuitry requirement to operate at some higher multiple frequency than the final output desired. Implementation of the new invention typically uses a mixture of active and passive circuitry to generate the IQ signals required, and therefore can be considered to fall into the category 2) group discussed. However, to improve the upper frequency limit, the circuit architecture is designed to operate on the fundamental signal only, such that the full bandwidth of the circuit technology can be utilised.

According to the current invention, apparatus for generating in phase and quadrature signals comprises the elements recited in claim 1 attached hereto.

According to a second aspect of the invention, a method of generating in-phase and quadrature signals comprises the steps set out in claim 3 attached hereto.

Using a single reference signal as an input, two output signals are generated at the same frequency. The relative amplitudes of these signals contain phase error information. An error signal is derived by amplitude comparison, and then fed back to a phase control element in a closed loop manner. The method proposed ensures that when the output amplitudes are equal then the output signals will be in phase quadrature. All signal processing is performed at the fundamental frequency, enabling wider bandwidth and higher frequency operation to be achieved, than could otherwise be realised using standard circuits based on frequency dividers.

The core solution of the current invention is based on the generation of two signals according to the trigonometric identities shown below as equations 1 and 2. Amplitudes of the tones generated are compared and the result of this comparison is applied via a closed loop feedback to a phase control element. When the amplitudes are exactly in balance, the two signals will be in perfect quadrature. Expanding this in detail:

Consider the well known trigonometric identities:

$$\sin(A) + \sin(B) = 2.\cos(\tfrac{1}{2}(A - B)).\sin(\tfrac{1}{2}(A + B)) \qquad \text{Equation 1}$$

$$\sin(A) - \sin(B) = 2.\sin(\tfrac{1}{2}(A - B)).\cos(\tfrac{1}{2}(A + B)) \qquad \text{Equation 2}$$

Defining the input reference signal to be $\sin(\omega t)$, and the variable phase control element to be $2\theta$, to generate the first tone, a phase delay and summing circuit is used to realise the first trig identity:

$$\sin(\omega t + 2\theta) + \sin(\omega t) = 2.\cos(\theta).\sin(\omega t + \theta) \qquad \text{Equation 3}$$

To generate the second tone, a phase delay and summing circuit is used to realise the second trig identity:

$$\sin(\omega t + 2\theta) - \sin(\omega t) = 2.\sin(\theta).\cos(\omega t + \theta) \qquad \text{Equation 4}$$

The right hand side of the last two equations can be considered as an amplitude term, multiplied by a carrier term. Setting these amplitude terms to be equal:

$$2.\cos(\theta) = 2.\sin(\theta) \quad \text{…only true when } \theta \text{ is } 45°, 225° \text{ etc (or } \pi/4 \text{ radians, } 5\pi/4$$

radians, etc).

Applying these repeating values to the right hand side of the full equations yields:

$$\sqrt{2}.\cos\left(\omega t + \frac{\pi}{4}\right) \quad \& \quad \sqrt{2}.\sin\left(\omega t + \frac{\pi}{4}\right)$$

Hence we have two signals in perfect amplitude balance and perfect quadrature, by virtue of the sine/cosine relationship.

To summarise, these tones are gene rated by detecting and comparing the amplitude terms to generate an error signal, and then applying the error signal as feedback to a variable phase element. Once the loop settles to zero error signal, perfect quadrature signals result.

This method overcomes the frequency limitation of the previously described divider based circuits, since all signal processing is done at the fundamental frequency, and so circuit operation can be achieved to the limit of circuit technology employed.

The invention will now be further described by way of non-limiting example with reference to the appended figures in which:

Figure 1    illustrates a pair of IQ signals;

Figure 2    illustrates a complete set of balanced IQ signals;

Figure 3      illustrates a wideband local oscillator scheme according to a first embodiment of the invention;

Figure 4      illustrates a wideband local oscillator scheme according to a second embodiment of the invention;

Figure 5      shows a graph of the error signal used to control the variable phase offset applied to a source signal in accordance with the current invention;

Figure 6      illustrates a wideband local oscillator scheme according to a third embodiment of the invention;

Figure 7      is a phase diagram which illustrates the effects of an amplitude mismatch going into the summers, or a gain mismatch going into the error amplifier in a particular embodiment of the invention;

Figure 8      illustrates the effect of gain imbalance in the diode detectors for a particular embodiment of the invention.

Figure 9      is a phase diagram which illustrates the effects of gain errors in the diode detectors for a particular embodiment of the invention;

Figure 10     illustrates a wideband local oscillator scheme according to a fourth embodiment of the invention;

Figure 11     illustrates a variant of the scheme illustrated in figure 10;

Figure 12     illustrates a possible implementation of a phase shift element and

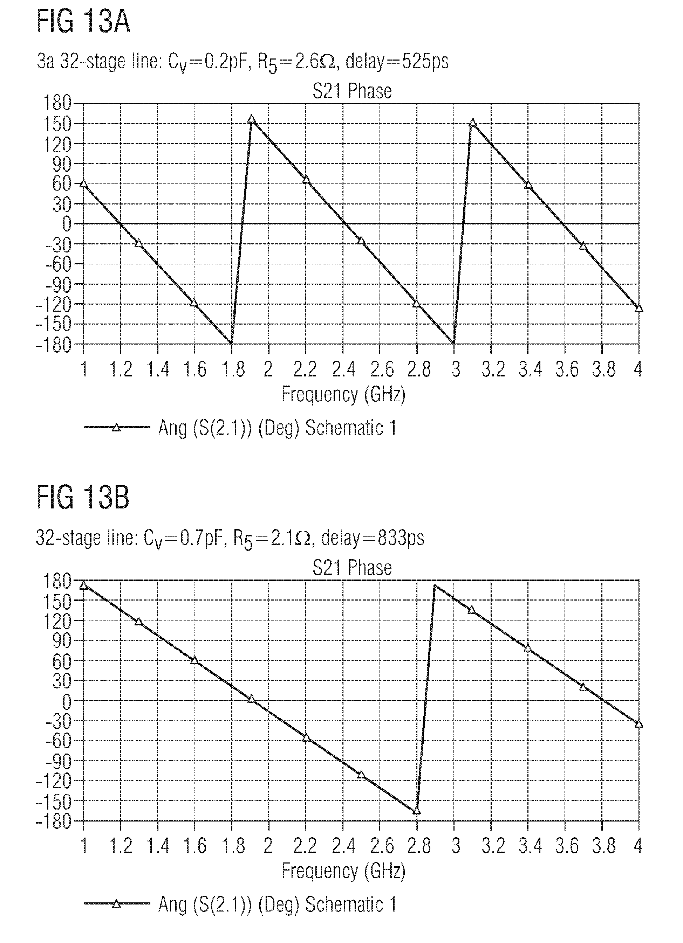

Figure 13     illustrates the results of modelling a phase shift element according to figure 12.

The following schemes are only presented with single ended I & Q outputs being generated. Parallel systems can be used to generate all four balanced signals according to the previous analysis.

## Example 1

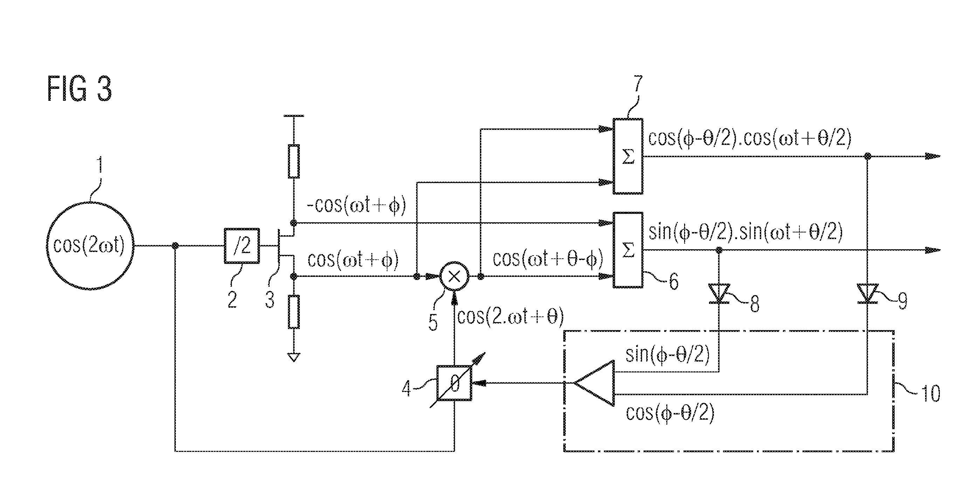

Referring to figure 3, a quad-LO generator according to the present invention uses an oscillator 1, at twice the LO frequency $\cos(2\omega t)$, a divider by two 2, and a phase-splitter 3. The outputs from the phase-splitter 3 are $\cos(\omega t+\phi)$ and $-\cos(\omega t+\phi)$ respectively, where $\phi$ is an arbitrary phase offset.

The $\cos(2\omega t)$ signal is also adjusted by a phase shifter 4 by an offset $\theta$ to give $\cos(2\omega t+\theta)$, which is mixed at mixer 5 with the $\cos(\omega t+\phi)$ output from the phase-splitter 3.

The product: $2.\cos(2\omega t+\theta).\cos(\omega t+\phi)=\cos(3\omega t+\theta+\phi)+\cos(\omega t+\theta-\phi)$ has the 3rd harmonic $\cos(3\omega t+\theta+\phi)$ removed by a low pass filter (not shown) and is then added by summer 6 to the second output from the phase-splitter 3 $-\cos(\omega t+\phi)$ to give:

$$\cos(\omega t + \theta - \phi) - \cos(\omega t + \phi) = 2.\sin(\phi - \theta/2).\sin(\omega t + \theta/2) \qquad \text{Equation 5}$$

(Note. Summers 6 (and 7) can be passive devices, implemented as three resistors connected in a triangle. This introduces a 6dB loss which cancels the multiplier of 2 in the right hand side of equation 5).

Similarly, the product is filtered and added by summer 7 to the other phase-splitter output to give:

$$\cos(\omega t + \theta - \phi) + \cos(\omega t + \phi) = 2.\cos(\phi - \theta/2).\cos(\omega t + \theta/2)$$

The outputs from the two summers are therefore in perfect quadrature, having $2.\sin(\phi-\theta/2)$ and $2.\cos(\phi-\theta/2)$ amplitude terms.

If we now measure the amplitude of the two outputs using diode detectors 8, 9, we can force the amplitudes to match by setting $(\phi-\theta/2)=\pi/4$, using a feedback phase-control loop 10.

## Example 2

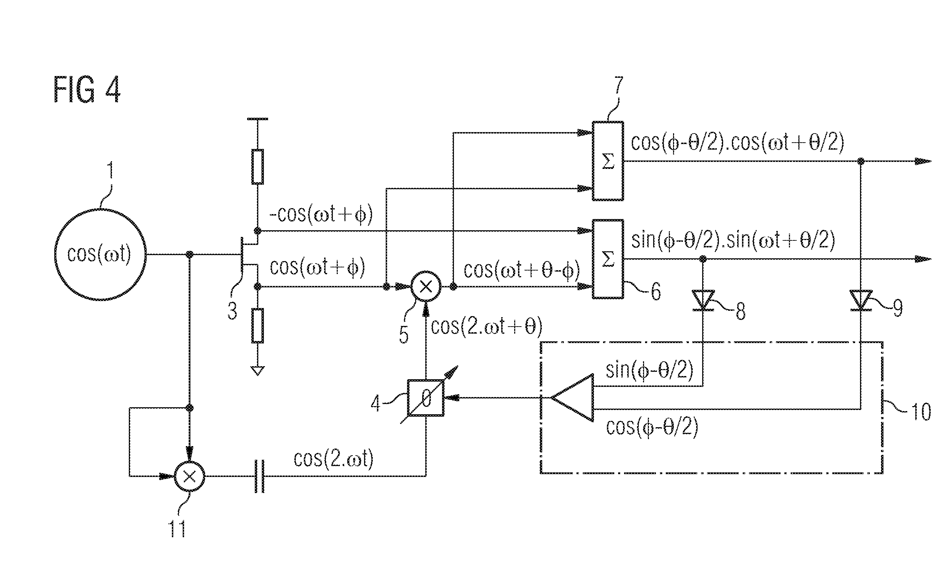

Another embodiment of the invention, shown in figure 4, eliminates the divider (item 2 of figure 3), and instead doubles the reference oscillator using a mixer 11.

The quad-LO generator represented in figure 4 uses an oscillator 1 at the LO frequency $\cos(\omega t)$, which is phase-split by splitter 3 and doubled using a mixer. The outputs from the phase-splitter 3 are $\cos(\omega t+\phi)$ and $-\cos(\omega t+\phi)$ respectively, where $\phi$ is the phase offset of the splitter plus any tracking.

The $\cos(2\omega t)$ signal is adjusted by phase adjuster 4 by an offset $\theta$ to give $\cos(2\omega t+\theta)$, which is mixed by mixer 5 with the $\cos(\omega t+\phi)$ output from the phase-splitter 3.

The product: $2.\cos(2\omega t+\theta).\cos(\omega t+\phi)=\cos(3\omega t+\theta+\phi)+\cos(\omega t+\theta-\phi)$ is again filtered to remove the third harmonic before being added by summer 6 to the second output from the phase-splitter 3 $-\cos(\omega t+\phi)$ to give, ignoring the 3$^{rd}$-harmonic:

$$\cos(\omega t+\theta-\phi)-\cos(\omega t+\phi)=2.\sin(\phi-\theta/2).\sin(\omega t+\theta/2)$$

Similarly, the product is filtered and added to the other phase-splitter output to give:

$$\cos(\omega t+\theta-\phi)+\cos(\omega t+\phi)=2.\cos(\phi-\theta/2).\cos(\omega t+\theta/2)$$

Again, summers 6 and 7 introduce a 6dB attenuation

The outputs from the two summers 6 and 7 are therefore in perfect quadrature, having $2.\sin(\phi-\theta/2)$ and $2.\cos(\phi-\theta/2)$ amplitude terms.

If we now measure the amplitude of the two outputs using diode detectors 8, 9, we can force the amplitudes to match by setting $(\phi-\theta/2)=\pi/4$ or $(\phi-\theta/2)=5\pi/4$, using a phase-control loop 10. The phase ambiguity can be avoided by limiting the range of $\theta$. Phase offsets in both mixers are also compensated by the loop.

The phase correction element can be implemented by a number of methods. Firstly it is necessary to gauge the range of phase shift required. To do this, it is necessary to set limits on the range of $\phi$ over the required operating band and over the temperature range. This involves modelling that is well within the capabilities of a person skilled in the art.

Next, the behaviour of the amplitude balance loop is considered.

The amplitude of the two detector signals are proportional to $|\sin(\phi-\theta/2)|$ and $|\cos(\phi-\theta/2)|$. These detected amplitudes balance at $(\phi-\theta/2)=\pi/4$, $(\phi-\theta/2)=3\pi/4$, $(\phi-\theta/2)=5\pi/4$ and $(\phi-\theta/2)=7\pi/4$. However, based on the polarity of the feedback, only two of these balance points can result in a stable lock: $(\phi-\theta/2)=\pi/4$ and $(\phi-\theta/2)=5\pi/4$.

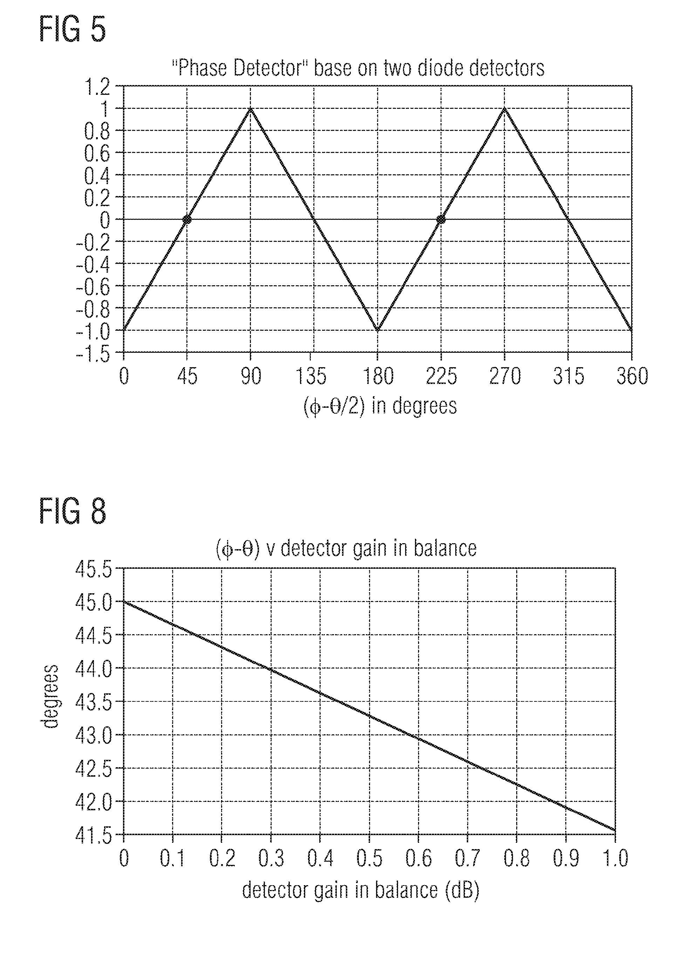

The loop error signal is: $|\sin(\phi-\theta/2]|-|\cos(\phi-\theta/2)|$. A plot of this function is shown in figure 5.

Note that the lock points can be switched from $\pi/4$ and $5\pi/4$, to $3\pi/4$ and $7\pi/4$, by inverting the error amplifier polarity to $|\cos(\phi-\theta/2)|-|\sin(\phi-\theta/2)|$. In this case, the same quadrature output terms are generated but with a sign inversion.

Removal of the high frequency (3$^{rd}$ harmonic) components from the output of mixers 5 examples 1 and 2 requires the use of a filter which introduces an inherent bandwidth limitation to the apparatus.

## Example 3

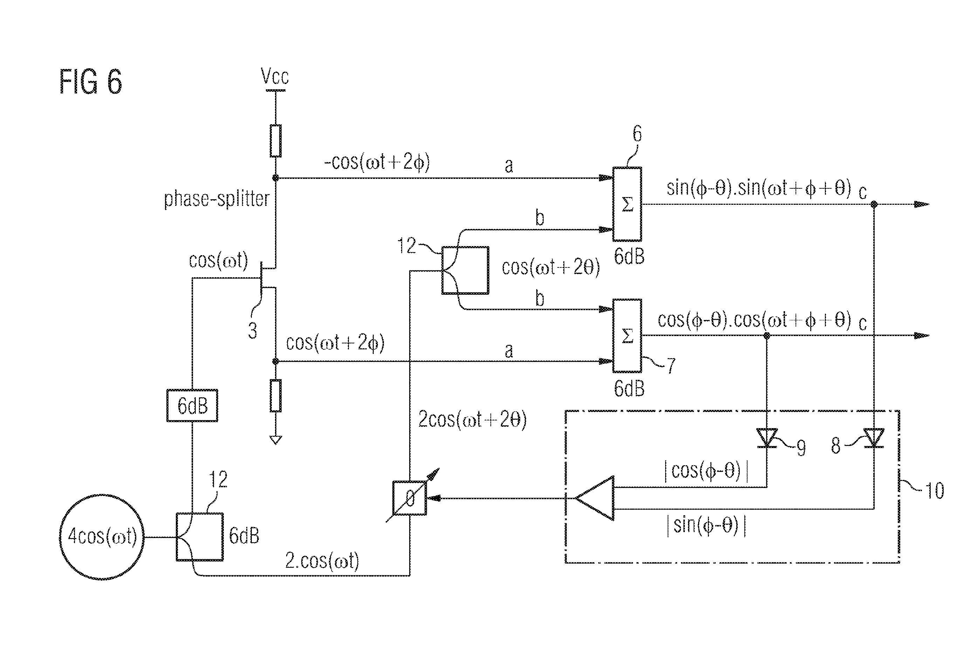

Referring to figure 6 the similarly labelled lines a, b and c have to be matched in length. This embodiment does not require the use of mixers. Note that at the summers 6,7, signal amplitudes must be carefully matched.

The 6dB passive splitters 12 and summers 6, 7 can be implemented using three equal resistors, which ensures wideband operation. The phase-splitter 3 and phase-controller are shown as unity gain.

In the ideal case with matched amplitudes, the summer equations are:

$$\cos(\omega t+2\theta)-\cos(\omega t+2\phi)=2.\sin(\phi-\theta).\sin(\omega t+\phi+\theta) \qquad \text{Equation 4}$$

$$\cos(\omega t + 2\theta) + \cos(\omega t + 2\phi) = 2.\cos(\phi - \theta).\cos(\omega t + \phi + \theta) \qquad \text{Equation 5}$$

The two summer outputs are in quadrature. The amplitudes balance when the control loop is locked to $(\phi-\theta)$ $=\pi/4$ or to $(\phi-\theta)=5\pi/4$.

Using this scheme, the issue of quadrature generation comes down to carefully controlled amplitudes and gains.

We now consider the effects of an amplitude mismatch going into the summers, or a gain mismatch going into the error amplifier.

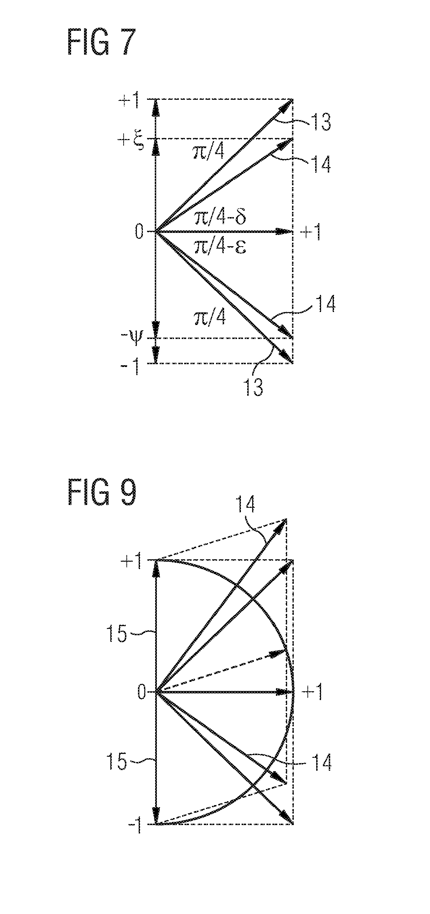

The diagram shown in figure 7 corresponds to the situation where the two gains of the phase-splitter are diminished by factors of $\xi$ and $\psi$ respectively. $\theta$ has been set to 0.

In the absence of gain error, the resultant vectors 13 are set to $\pm\pi/4$. With gain errors $\xi$ and $\psi$, the resultant vectors 14 move to... $\dfrac{\pi}{4} - \delta = \tan^{-1}(\xi)$ and

$\dfrac{\pi}{4} - \varepsilon = \tan^{-1}(\psi)$, so that the overall quadrature error becomes ...

$$\varepsilon + \delta = \frac{\pi}{2} - \tan^{-1}(\xi) - \tan^{-1}(\psi).$$

Table 1 shows the overall quadrature error against the two phase-splitter gain errors (dB). For quadrature error less than 2.5°, the total gain mismatch must be less than $\approx 0.76$dB.

Table 1

| dB | 0.00 | -0.10 | -0.20 | -0.30 | -0.40 | -0.50 | -0.60 | -0.70 | -0.80 |
|---|---|---|---|---|---|---|---|---|---|
| 0.00 | 0.00 | 0.33 | 0.66 | 0.99 | 1.32 | 1.65 | 1.98 | 2.31 | 2.63 |
| -0.10 | 0.33 | 0.66 | 0.99 | 1.32 | 1.65 | 1.98 | 2.31 | 2.64 | 2.96 |
| -0.20 | 0.66 | 0.99 | 1.32 | 1.65 | 1.98 | 2.31 | 2.64 | 2.97 | 3.29 |
| -0.30 | 0.99 | 1.32 | 1.65 | 1.98 | 2.31 | 2.64 | 2.97 | 3.30 | 3.62 |
| -0.40 | 1.32 | 1.65 | 1.98 | 2.31 | 2.64 | 2.97 | 3.30 | 3.63 | 3.95 |
| -0.50 | 1.65 | 1.98 | 2.31 | 2.64 | 2.97 | 3.30 | 3.63 | 3.95 | 4.28 |
| -0.60 | 1.98 | 2.31 | 2.64 | 2.97 | 3.30 | 3.63 | 3.95 | 4.28 | 4.61 |
| -0.70 | 2.31 | 2.64 | 2.97 | 3.30 | 3.63 | 3.95 | 4.28 | 4.61 | 4.94 |
| -0.80 | 2.63 | 2.96 | 3.29 | 3.62 | 3.95 | 4.28 | 4.61 | 4.94 | 5.27 |

The error surface is almost planar for small gain mismatch.

Next we consider the effects of gain imbalance in the diode detectors. The nominal loop error signal is: $|\sin(\phi-\theta)|-|\cos(\phi-\theta)|$. In the presence of detector gain error, $\mu$, the positive balance point is: $\sin(\beta).\sin(\phi-\theta)-\cos(\beta).\cos(\phi-\phi)=0$, where $\tan(\beta)=\mu$ represents the detector gain error. The balance point is thus:

$$\cos(\beta + \phi - \theta) = 0, \text{ i.e. } (\phi - \theta) = \frac{\pi}{2} - \tan^{-1}(\mu).$$

Figure 8 shows the plot of $(\phi-\theta)$ versus $20.\log_{10}(\mu)$. We see that for 0.3dB detector gain imbalance, $(\phi-\theta)$ is in error by 1.0°.

Provided that the amplitudes into the two summers are matched, gain errors in the diode detectors do not affect the quadrature relationship of the outputs. This can be seen easily from the figure 9.

For equal vector magnitudes the errand vector sums 14 always bisect the angles to the two phase-splitter outputs 15. Hence, provided the phase-splitter is working correctly, the outputs from the summers 6, 7 will always be in quadrature, irrespective of gain imbalance in the diode detectors 8,9.

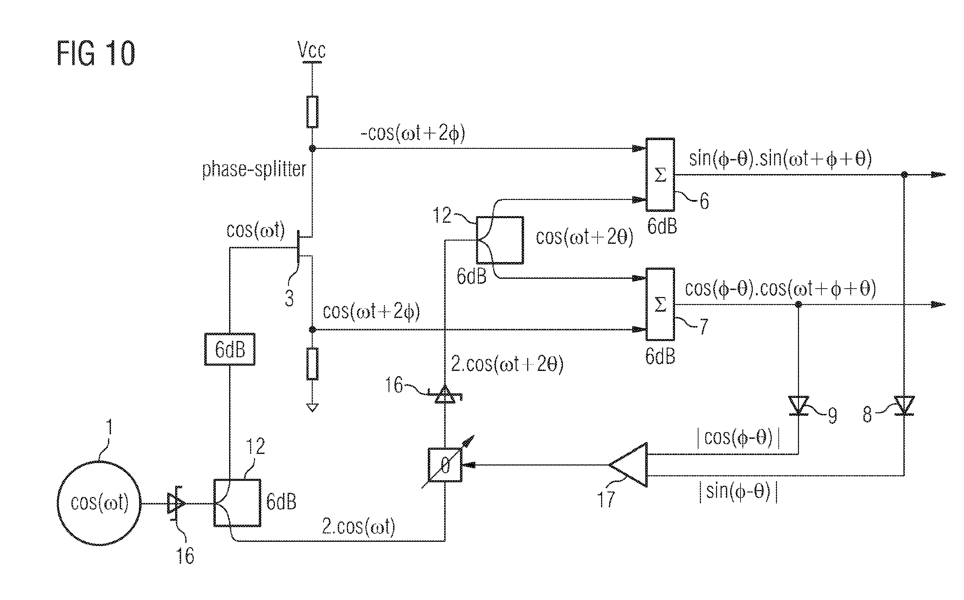

Figure 10 shows how the inclusion of two limiting amplifiers 16 can facilitate tight control of the vector amplitudes going into the two summers 6, 7, and thus ensure accurate wideband quadrature performance.

The 6dB splitters 12 and 6dB summers 6, 7 are made up from three equal resistors, the phase splitter 3 is a single transistor with two resistors. The error amplifier comprises two diodes 8, 9 plus two capacitors (not shown) and a differential amplifier 17.

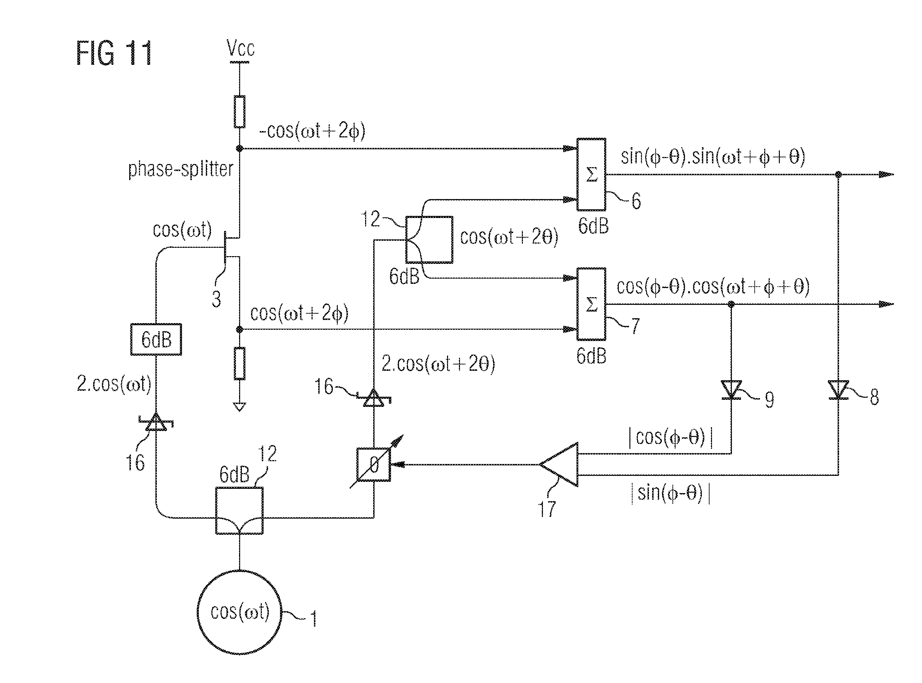

The variant shown in figure 11 uses identical limiting amplifiers 16, which can therefore be well matched.

With the exception of the limiting amplifiers 16, each element of the scheme is operated in linear mode, which thus avoids harmonic generation.

We now consider the phase shifter. First, we examine a phase shifter which uses a lumped reflection-type branch-line coupler and various forms of reactive termination, using transistors connected as varactors.

The reflective load can take a number of forms: capacitive, resonant, dual resonant, dual resonant with transformation, etc.

The branch-line coupler elements are evaluated using

$$C_1 = \frac{1}{\omega_0 . Z_0} , \quad L_1 = \frac{Z_0}{\omega_0 . \sqrt{2}} , \quad C_2 = \frac{1}{\omega_0^2 . L_1} - C_1$$

Simulation with $\omega_0$ = 2GHz and $Z_0$ = 50Ω; $C_1$ = 1.592pF, $L_1$ = 2.813nH, $C_2$ = 0.659p shows that the lumped reflective branch-line coupler gives satisfactory phase shift properties only over narrow bandwidth.

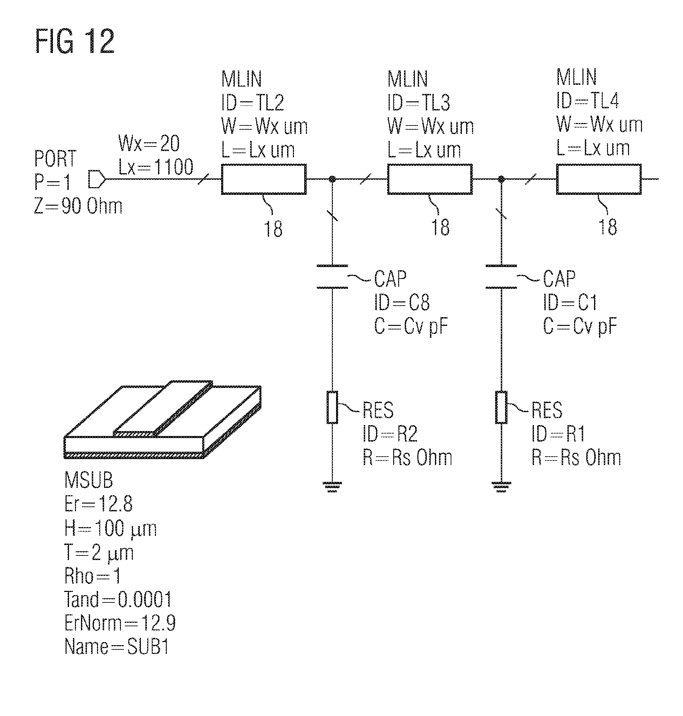

Next, we evaluate a lumped transmission line with varactor-connected shunt transistors as illustrated in figure 12

Each transmission line section is formed as a series-L and shunt-C. The series inductance elements 18 have been modelled as 1100$\mu$m lengths of microstrip line, 20$\mu$m wide by 2$\mu$m thick, of gold on a dielectric height of 100$\mu$m, with $\varepsilon_r$ = 12.9 and tan$\delta$ = 0.0001.

At 1 GHz, each section provides 3.44° of adjustment over $C_v$ = 0.2p to 0.7p, the phase control range scaling with frequency. Over 1GHz to 4GHz the return loss is better than 10dB.

Clearly, the number of sections required will depend on a detailed simulation of the phase-splitter behaviour.

For an integrated circuit implementation, it is more likely that an integrated phase shifter will be used that is based on a much simpler and cruder approach, for example using the input-to-output phase variation that a chain of active devices under variable DC bias control would give. Such an arrangement would not have a linear phase control response with control signal, but this does not matter since the circuit operates in closed loop, and the effects of any such non-linearity would be removed.

Notes on Control Loop Locking Philosophy

Referring back to figure 5, recall that the outputs lock on $\pi/4$ radians or $5\pi/4$ radians, but cannot locked on the other 'zero error' points of $3\pi/4$ radians or $7\pi/4$ radians, since the polarity of the error output will drive the phase in the wrong direction (ie towards either $\pi/4$ radians or $5\pi/4$ radians).

Whilst this inherent safety feature is very useful, some thought still needs to be given to reliable operation on start up, good immunity to glitches and circuit noise, and also prevention of the possibility that the circuit will try and phase track off the top end of the scale available. Discussing these in detail:

The control loop is unlikely to contribute significantly to differential phase noise to the two outputs, since any noise in the error feedback will affect both signals equally. Never the less the use of some integration in the feedback path, to improve robustness of the circuit against disturbances, is possible. Such integration may just be realised through the time constants of the two amplitude detectors. It should be noted that provision of a 'reset' line at this point is desirable, such that on power up, the phase can be reset to its minimum value (or any safe value in the lock-in range of the detector), and then allowed to track back to the $\pi/4$ radian point, rather than skip to a higher multiple of this. Also, in the event of a glitch, it is possible that a circuit locked to the $5\pi/4$ radian point, for example, could try and jump to the next stable phase state of $9\pi/4$ radians. In some implementations this might be outside the range of the phase shifter. In this case the circuit would effectively 'hit the end stop' and the circuit would be stuck in an error state with no way out. In this case an automatic reset can be configured from the phase shifters input control signal - a reset will be initiated, if the absolute level exceeds a predetermined value.

It is proposed that these 'reset' safety features are implemented such that they operate autonomously when required, to yield a robust closed loop analogue system.

**Claims**

1.  Apparatus for generating in-phase and quadrature signals comprising:

means for generating a source signal;
means for deriving a first signal and a second signal from the source signal, wherein the first and second signals each comprise an amplitude term and a phase term and the phase terms differ in phase by 90° when the amplitude terms are equal;
means for varying the phase difference between the first signal and the second signal and
means for deriving an error signal from a comparison of the amplitude terms of the first and second signals arranged so that the means for varying the phase difference between the first signal and the second signal is responsive to the error signal.

2. The apparatus of claim 1, wherein the means for deriving a first signal and a second signal from the source signal includes means for deriving one or more intermediate signals and the means for varying the phase difference between the first signal and the second signal comprises a phase shift element arranged to introduce a phase shift in at least one of said intermediate signals.

3. A method of generating in-phase and quadrature signals comprising the steps of:

generating a source signal;
deriving a first signal and a second signal from the source signal, wherein the first and second signals each comprise an amplitude term and a phase term and the phase terms differ in phase by 90° when the amplitude terms are equal;
comparing the amplitude terms of the first and second signals;
deriving an error signal representative of the difference between the first and second signals and
varying the phase difference between the first signal and the second signal in response to the error signal.

# FIG 1

## IQ Signals

# FIG 2

## IQ Signals and their compliments

FIG 3

EP 1 764 912 A2

FIG 4

$cos(\phi-\theta/2).cos(\omega t+\theta/2)$

$sin(\phi-\theta/2).sin(\omega t+\theta/2)$

$cos(\omega t+\theta-\phi)$

$cos(2.\omega t+\theta)$

$sin(\phi-\theta/2)$

$cos(\phi-\theta/2)$

$-cos(\omega t+\phi)$

$cos(\omega t+\phi)$

$cos(2.\omega t)$

$cos(\omega t)$

$\Sigma$ 7

$\Sigma$ 6

8

9

10

5

4

3

1

11

# FIG 5

"Phase Detector" base on two diode detectors

(φ-θ/2) in degrees

# FIG 8

(φ-θ) v detector gain in balance

degrees

detector gain in balance (dB)

# FIG 6

FIG 7

FIG 9

FIG 10

EP 1 764 912 A2

FIG 11

EP 1 764 912 A2

EP 1 764 912 A2

## FIG 12

**PORT**
P=1
Z=90 Ohm

Wx=20
Lx=1100

**MLIN**
ID=TL2
W=Wx um
L=Lx um

18

**MLIN**
ID=TL3
W=Wx um
L=Lx um

18

**MLIN**
ID=TL4
W=Wx um
L=Lx um

18

**CAP**
ID=C8
C=Cv pF

**CAP**
ID=C1
C=Cv pF

**RES**
ID=R2
R=Rs Ohm

**RES**
ID=R1
R=Rs Ohm

**MSUB**
Er=12.8
H=100 μm
T=2 μm
Rho=1
Tand=0.0001
ErNorm=12.9
Name=SUB1

## FIG 13A

3a 32-stage line: $C_V = 0.2pF$, $R_5 = 2.6\Omega$, delay $= 525ps$

## FIG 13B

32-stage line: $C_V = 0.7pF$, $R_5 = 2.1\Omega$, delay $= 833ps$